## Europäisches Patentamt
## European Patent Office
## Office européen des brevets

(19)

(11) Numéro de publication: **0 329 522**
**A1**

(12) # DEMANDE DE BREVET EUROPEEN

(21) Numéro de dépôt: **89400333.4**

(22) Date de dépôt: **07.02.89**

(51) Int. Cl.⁴: **H 01 L 21/20**
**H 01 L 21/31, C 30 B 1/02,**
**C 30 B 29/06**

(30) Priorité: **10.02.88 FR 8801584**

(43) Date de publication de la demande:
**23.08.89 Bulletin 89/34**

(84) Etats contractants désignés: **DE GB NL**

(71) Demandeur: **ETAT FRANCAIS représenté par le Ministre des Postes, des Télécommunications et de l'Espace (CENTRE NATIONAL D'ETUDES DES TELECOMMUNICATIONS) 38-40 rue du Général Leclerc F-92131 Issy-les-Moulineaux (FR)**

(72) Inventeur: **Haji, Lazhar**
**Résidence Beauchamp Bât.B. 74 rue de Tréguier**
**F-22300 Lannion (FR)**

**Loisel, Bertrand**
**19 rue de Verdun Brelevenez**
**F-22300 Lannion (FR)**

**Joubert, Pierre**
**Route de Kerdelen Rospez**
**F-22300 Lannion (FR)**

(74) Mandataire: **Mongrédien, André et al**
**c/o BREVATOME 25, rue de Ponthieu**
**F-75008 Paris (FR)**

(54) **Procédé de depot d'une couche polycristalline a gros grains, couche obtenue et transistor pourvu d'une telle couche.**

(57) Procédé de dépôt d'une couche polycristalline à gros grains, couche obtenue et transistor pourvu d'une telle couche.

Le procédé consiste à déposer une couche de silicium amorphe (4) sur un substrat amorphe (2), à une température inférieure à 600°C, à déposer sur cette couche amorphe une couche de silicium polycristallin (6), le dépôt de la couche de silicium polycristallin (6) entraînant une recristallisation en phase solide de la couche amorphe sous forme polycristalline (4a) et à éliminer la couche supérieure polycristalline.

FIG. 2

EP 0 329 522 A1

## Description

## PROCEDE DE DEPOT D'UNE COUCHE POLYCRISTALLINE A GROS GRAINS, COUCHE OBTENUE ET TRANSISTOR POURVU D'UNE TELLE COUCHE

L'invention a pour objet un procédé de dépôt d'une couche polycristalline comportant des gros grains monocristallins. Elle se rapporte en particulier au dépôt de couches minces semiconductrices notamment de silicium polycristallin pour la réalisation de composants et de circuits électroniques sur des substrats isolants amorphes, en grande surface principalement.

Le domaine visé par l'invention est plus particulièrement celui des transistors en couches minces (TCM) en silicium polycristallin pour lesquels, des couches ultra-minces (épaisseur $\leq$ 100 nm) à très gros grains monocristallins ($\geq$ 200 nm) autorisent de très fortes mobilités d'effet de champ. Cependant, le procédé selon l'invention peut être appliqué à tous les domaines de la micro-électronique où des couches semiconductrices ou métalliques polycristallines, minces ou épaisses, sont actuellement utilisées.

Le dépôt de couches semiconductrices polycristallines, notamment de silicium polycristallin, sur un substrat isolant et amorphe, se fait par diverses méthodes.

La méthode la plus utilisée est celle du dépôt par décomposition chimique en phase vapeur basse pression de silane (LPCVD: Very Low Pressure Chemical Vapor Deposition, en terminologie anglo-saxonne). Cette méthode est notamment décrite dans l'article de Joubert et al. "The effect of low pressure on the structure of LPCVD polycristalline silicon films", pp. 2541-2545, J. Electrochem. Soc. Solid-State Science and Technology, octobre 1987.

La taille des grains de silicium polycristallin déposé sur un substrat amorphe par cette méthode peut dépasser plusieurs centaines de nanomètres à condition que l'épaisseur de la couche dépasse le micromètre et que la température de dépôt soit supérieure à 600°C.

Cette première méthode ne permet donc pas l'obtention, pour des températures inférieures à 600°C, de couches polycristallines extra-minces à gros grains. En effet, la taille des grains obtenus est nettement inférieure à l'épaisseur de la couche. En outre, on observe la présence d'une couche d'interface, entre le substrat et la couche de silicium polycristallin à gros grains, de quelques dizaines de nm d'épaisseur, formée de très petits grains ($\leq$ 10 nm) orientés au hasard, et ce, quelle que soit la température de dépôt.

La seconde méthode connue de dépôt d'une couche de silicium polycristallin est l'évaporation sous ultra-vide comme décrit dans l'article de Matsui et al. JAP 53(2) 1982 intitulé, "Low-temperature formation of polycristalline silicon films by molecular beam deposition", p.995-998. Dans cet article, il est montré que la texture et la taille des grains dépendent fortement de l'épaisseur du dépôt. La température de dépôt peut être aussi basse que 400°C.

Malheureusement, cette seconde méthode est très lourde du fait de l'emploi de l'ultra-vide. En outre, la taille des grains monocristallins croît avec la température du substrat et avec l'épaisseur de la couche. Ceci ne permet donc pas d'obtenir des couches ultra-minces ($\leq$ 100 nm) à très gros grains.

La troisième méthode connue de dépôt d'une couche de silicium polycristallin est la recristallisation en phase solide d'une couche amorphe déposée par CVD ou LPCVD, comme décrit dans l'article "Thin Solid Films", 124 (1985), pp. 171-177, de Bisaro et al "Crystallization study of chemically vapour-deposited amorphous silicon films by in situ X-ray diffraction". Cette recristallisation a l'avantage d'être effectuée à basses températures, comprises entre 578°C et 658°C. En revanche, la taille des grains monocristallins obtenue est très inférieure au micromètre, typiquement de 60 nm.

Une quatrième méthode pour l'obtention de couches minces de silicium polycristallin à gros grains sur un substrat amorphe est celle utilisée par Iverson et Reif et est décrite par exemple dans l'article J. Appl. Phys. 62(5) du 1er Septembre 1987 pp. 1675-1681, "Recrystallization of amorphized polycrystalline silicon films on $SiO_2$ : Temperature dependence of the crystallization parameters. Après le dépôt d'une couche mince à petits grains par la méthode classique LPCVD, la couche est amorphisée par un faisceau d'ions $Si^+$ puis recristallisée en phase solide par un recuit à basse température entre 580 et 640°C.

Cette quatrième méthode est complexe et lourde, car elle nécessite un implanteur et une longue durée de recuit. Par exemple à 580°C, il faut plus de 80 heures pour obtenir la recristallisation. De plus, la taille des grains croît lorsque la température de recuit décroît. Donc pour obtenir de gros grains il faut recuire longtemps à faible température.

Pour le dépôt d'autres couches semiconductrices polycristallines ou de couches métalliques polycristallines, les techniques utilisées sont similaires à celles décrites ci-dessus pour le silicium et leurs inconvénients sont de même nature.

L'invention a justement pour objet un procédé de dépôt d'une couche polycristalline comportant des gros grains monocristallins, permettant de remédier aux différents inconvénients ci-dessus.

En particulier, il permet le dépôt de couches extra-minces d'épaisseur au plus égale à 100 nm comportant des grains monocristallins, d'au moins 200 nm de large, de façon simple et rapide, en utilisant des températures de dépôt et/ou de recristallisation, inférieures à celles utilisées dans l'état de la technique.

De façon plus précise, l'invention a pour objet un procédé de dépôt d'une couche polycristalline sur un substrat amorphe, consistant à : (a) déposer sur le substrat une première couche en matériau amorphe à une température inférieure à 600°C ; (b) déposer sur cette première couche, une seconde couche de matériau polycristallin, le dépôt de la seconde couche entraînant une recristallisation en phase solide de la première couche sous forme polycristalline ; et (c) éliminer la seconde couche de matériau polycristalline.

Ce procédé, ne comportant aucune étape critique, permet l'obtention d'une couche polycristalline extra-mince, au plus égale à 100 nm, ayant des grains monocristallins d'au moins 200 nm de large.

Ce procédé contrairement à certains procédés de l'art antérieur, ne nécessite aucune étape de recuit.

Ce procédé, en plus des avantages ci-dessus, permet l'obtention d'une couche polycristalline à gros grains monocristallins, sans présence d'une couche d'interface à petits grains monocristallins entre le substrat et la couche à gros grains.

Le procédé selon l'invention s'applique à tout type de matériau polycristallin, métallique ou semiconducteur. Toutefois, il s'applique avantageusement à des matériaux semiconducteurs dopés ou non notamment du type silicium, matériaux III-V et matériaux II-VI.

En outre, la première couche de matériau polycristallin peut être de nature chimique identique ou différente de celle de la seconde couche amorphe, à condition toutefois que le matériau polycristallin ne contienne pas des éléments chimiques pouvant diffuser facilement dans la couche amorphe pour les températures de dépôts utilisées. En particulier, le matériau polycristallin peut être du silicium polycristallin ou du GaAs, pour une couche amorphe de silicium.

La première et la seconde couches peuvent être déposées selon toutes les méthodes de dépôt de couches minces connues telles que l'évaporation sous vide, le dépôt par décomposition chimique en phase vapeur basse pression (LPCVD) ou assisté plasma (PECVD), la pulvérisation magnétron, etc... Avantageusement, la première et la seconde couches sont déposées par LPCVD.

Selon l'invention, le substrat est réalisé en un matériau choisi parmi la silice, les verres de silice et les verres borosilicatés. L'utilisation de verres borosilicatés comme substrat amorphe est possible, contrairement à certains procédés de l'art antérieur, étant donné que les températures mises en jeu sont basses, inférieures à 600°C.

Pour qu'il y ait recristallisation de la couche amorphe, il faut que la contrainte mécanique exercée par la couche polycristalline de dessus soit supérieure à une valeur critique, c'est-à-dire très élevée.

En d'autres termes, pour une couche amorphe en un premier matériau et une couche polycristalline en un second matériau de nature différente du premier matériau, il faut que les coefficients d'expansion thermique du premier et du second matériaux soient très différents. Par exemple pour une couche de silicium amorphe, on peut utiliser une couche polycristalline de Ti ou W. En revanche, pour une couche amorphe et une couche polycristalline en un même matériau, présentant donc des coefficients d'expansion très proches, il faut que le rapport des épaisseurs des deux couches soit favorable.

Pour une première couche amorphe d'épaisseur e et une seconde couche polycristalline d'épaisseur E notamment en silicium, il faut que le rapport des épaisseurs E/e soit supérieur à 1 et par exemple voisin de 2. En revanche, pour des premiers et seconds matériaux différents, le rapport E/e peut être supérieur ou inférieur à 1.

L'invention a aussi pour objet une couche polycristalline à gros grains obtenue par le procédé selon l'invention se caractérisant en ce que la couche présente une épaisseur au plus égale à 100 nm et des gros grains monocristallins dont la largeur est au moins égale à 200 nm.

L'invention a encore pour objet un transistor en couches minces réalisé sur un substrat amorphe, comportant une couche semiconductrice polycristalline extra-mince conforme à l'invention, comme couche active.

D'autres caractéristiques et avantages de l'invention ressortiront mieux de la description qui va suivre, donnée à titre illustratif et non limitatif, en référence aux figures annexées, dans lesquelles :

- les figures 1 à 3 représentent, schématiquement les différentes étapes du procédé de dépôt selon l'invention,

- la figure 4 représente schématiquement, en coupe longitudinale, un premier mode de réalisation d'un transistor MIS comportant une couche de silicium polycristallin extra-mince à gros grains, selon l'invention, et

- la figure 5 représente, schématiquement, en coupe longitudinale, un autre mode de réalisation d'un transistor MIS comportant une couche extra-mince de silicium polycristallin à gros grains, selon l'invention.

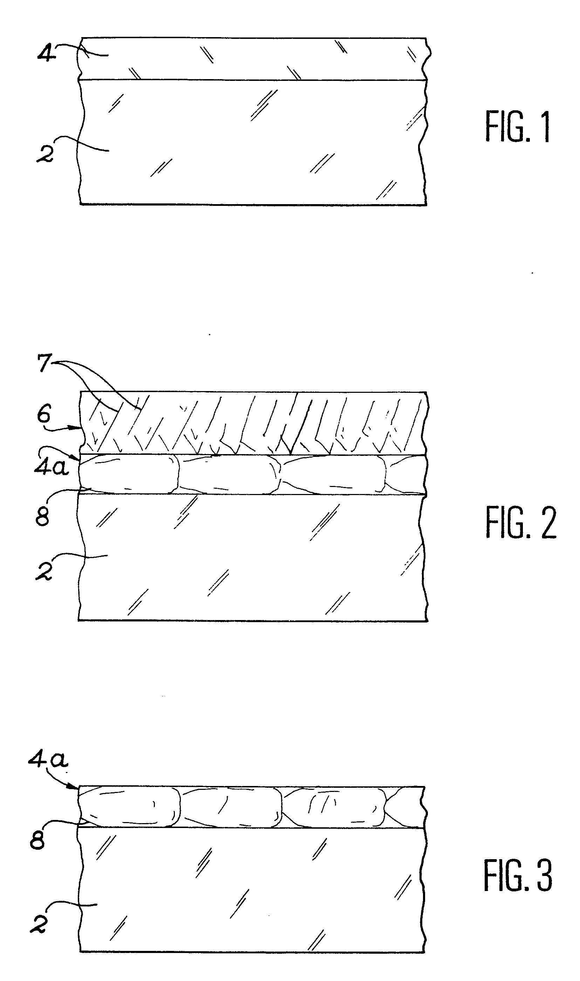

En référence à la figure 1, la première étape du procédé consiste à déposer sur un substrat en silice 2 une couche de silicium amorphe 4 de 70 nm d'épaisseur. Cette couche amorphe 4 est déposée par LPCVD à une température inférieure à 580°C et par exemple égale à 570°C, par décomposition de silane. Ce dépôt est réalisé dans une enceinte de dépôt où règne une pression élevée de l'ordre de 10 torrs (1 330 Pa).

L'enceinte de dépôt est ensuite portée à une température de l'ordre de 595°C et la pression régnant dans l'enceinte est abaissée à $5.10^{-2}$ torr (1,3 Pa). Dans ces conditions, on effectue le dépôt d'une couche de silicium polycristallin 6 sur la couche amorphe 4, de 150 nm d'épaisseur. Cette couche polycristalline 6 comporte des grains monocristallins 7 de 40 nm de large.

Sous l'effet des contraintes induites par la couche de silicium polycristallin 6, la couche amorphe 4 subit une recristallisation en phase solide, conduisant ainsi, comme représenté sur la figure 2, à l'obtention d'une couche polycristalline 4a comportant des gros grains monocristallins 8 de 200 nm au moins de large.

Pour déposer, dans une même enceinte de dépôt, une couche de silicium amorphe ou une couche de silicium polycristallin, il suffit de modifier soit la température de dépôt soit les pressions des gaz utilisés.

Les dépôts successifs d'une couche de silicium amorphe et d'une couche de silcium polycristallin peuvent être réalisés dans toute enceinte de dépôt dans laquelle on peut faire varier la pression et la température. Une machine LPCVD commerciale du type ASM permet les dépôts successifs d'une couche de silicium amorphe et d'une couche de silicium polycristallin.

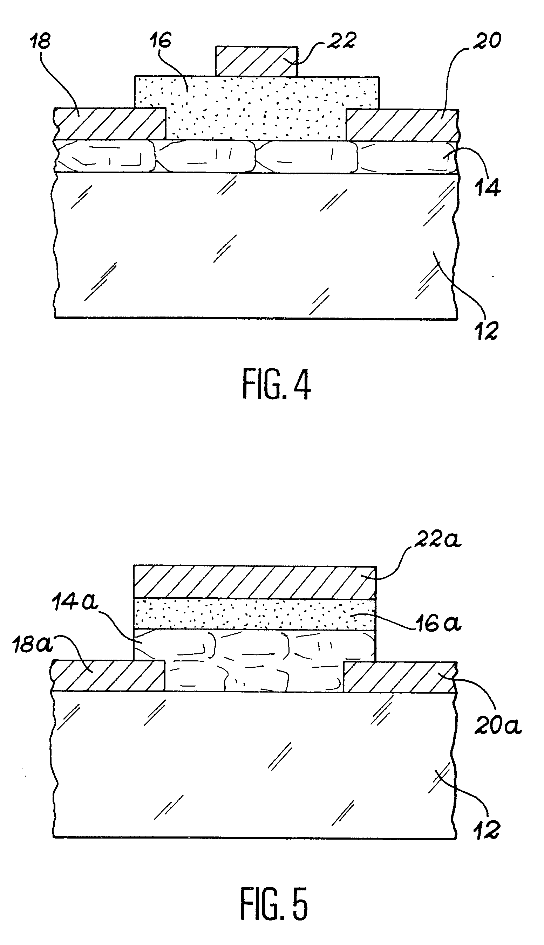

La dernière étape du procédé consiste à éliminer la couche 6 de silicium polycristallin soit par décapage sélectif en utilisant un plasma de SF₆ ou de CF₄ ou une solution de HNO₃-HF, soit par décapage contrôlé dans le temps. La structure obtenue est celle représentée sur la figure 3.

Avec le procédé selon l'invention, il est possible de déposer une couche de silicium polycristallin de 80 nm d'épaisseur présentant des grains monocristallins au moins égaux à 300 nm.

L'utilisation d'une couche supérieure 6 polycristalline est nécessaire pour permettre la recristallisation de la couche amorphe 4 sous-jacente. En effet, il a été vérifié qu'une couche de silicium amorphe seule ayant subi le même cycle de pression et de température que le matériau bicouche reste quasiment amorphe.

La couche extra-mince polycristalline à gros grains selon l'invention peut être utilisée dans des transistors en couches minces MIS tels que représentés sur les figures 4 et 5. Les différentes étapes de fabrication de ces transistors sont identiques à celles de l'art antérieur, à l'exception de l'étape de dépôt de la couche polycristalline à gros grains.

Le transistor MIS de la figure 4 comporte de façon connue, sur un substrat en verre 12, une couche 14 de silicium polycristallin obtenue par le procédé selon l'invention, de 50 nm d'épaisseur. Cette couche 14 est surmontée d'une couche isolante 16 notamment en nitrure de silicium de 300 nm d'épaisseur, gravée, afin de constituer l'isolant de grille du transistor.

De part et d'autre de cet isolant, on trouve des contacts ohmiques 18 et 20 de 200 nm d'épaisseur, notamment en aluminium, constituant respectivement la source et le drain du transistor. Surmontant la couche d'isolant 16 et disposée entre la source et le drain du transistor on trouve la grille 22 du transistor de 300 nm d'épaisseur, réalisée en aluminium.

Le transistor MIS représenté sur la figure 5 se différencie de celui représenté sur la figure 4 par le fait que la source 18a et le drain 20a du transistor sont réalisés directement sur le substrat en verre 12. Dans ce cas, la couche de silicium polycristallin 14a, déposée selon l'invention, est réalisée après les source et drain du transistor et comporte une partie séparant lesdits source et drain dont la largeur définit la longueur du canal du transistor.

Comme précédemment, la couche polycristalline 14a est surmontée d'une couche gravée 16a isolante, constituant l'isolant de grille puis d'une couche conductrice gravée 22a, constituant la grille du transistor.

**Revendications**

1. Procédé de dépôt d'une couche polycristalline sur un substrat amorphe, consistant à : (a) déposer sur le substrat (2, 12) une première couche (4) en matériau amorphe à une température inférieure à 600°C ; (b) déposer sur cette première couche (4), une seconde couche (6) de matériau polycristallin, le dépôt de la seconde couche entraînant une recristallisation en phase solide de la première couche (4a, 14, 14a) sous forme polycristalline, et (c) éliminer la seconde couche de matériau polycristallin.

2. Procédé de dépôt selon la revendication 1, caractérisé en ce que la seconde couche (6) est déposée à une température inférieure à 600°C.

3. Procédé de dépôt selon la revendication 1 ou 2, caractérisé en ce que la première (4) et la seconde (6) couches sont réalisées en des matériaux de même nature et présentent respectivement une épaisseur E et e et en ce que le rapport E/e est supérieur à 1.

4. Procédé de dépôt selon la revendication 1 ou 2, caractérisé en ce que la première (4) et la seconde (6) couches sont réalisées en des matériaux de nature différente, ces matériaux ayant des coefficients d'expansion thermique différents.

5. Procédé de dépôt selon l'une quelconque des revendications 1 à 4, caractérisé en ce que le matériau amorphe et le matériau polycristallin sont des matériaux semi-conducteurs.

6. Procédé de dépôt selon l'une quelconque des revendications 1 à 5, caractérisé en ce que le matériau amorphe est du silicium amorphe.

7. Procédé de dépôt selon l'une quelconque des revendications 1 à 5, caractérisé en ce que le matériau polycristallin est du silicium polycristallin.

8. Procédé de dépôt selon l'une quelconque des revendications 1 à 7, caractérisé en ce que la première couche (4) est déposée par la technique de dépôt chimique en phase vapeur à basse pression (LPCVD).

9. Procédé de dépôt selon l'une quelconque des revendications 1 à 8, caractérisé en ce que la seconde couche (6) est déposée par la technique de dépôt chimique en phase vapeur à basse pression (LPCVD).

10. Procédé de dépôt selon l'une quelconque des revendications 1 à 9, caractérisé en ce que le substrat (2, 12) est un matériau choisi parmi la silice, les verres de silice et les verres borosilicatés.

11. Couche polycristalline comportant des gros grains monocristallins, obtenue par le procédé selon l'une quelconque des revendications 1 à 10, caractérisée en ce que la couche (4a, 14, 14a) présente une épaisseur au plus égal à 100 nm et des grains monocristallins (8) dont la largeur est au moins égale à 200 nm.

12. Couche polycristalline selon la revendication 11, caractérisée en ce que la couche (4a, 14, 14a) est une couche de silicium.

13. Transistor en couches minces sur un substrat amorphe (12), caractérisé en ce qu'il comprend une couche polycristalline semiconductrice (14, 14a) selon la revendication 11 ou 12 comme couche active.

4

2

FIG. 1

7

6

4a

8

2

FIG. 2

4a

8

2

FIG. 3

FIG. 4

FIG. 5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | PATENT ABSTRACTS OF JAPAN, vol. 10, no. 317 (E-449)[2373], 28 octobre 1986; & JP-A-61 127 117 (SONY CORP.) 14-06-1986 * Résumé; figures * | 1-3,5-7 ,10 | H 01 L 21/20<br>H 01 L 21/31<br>C 30 B 1/02<br>C 30 B 29/06 |
| A | GB-A-2 130 009 (RCA CORP.) * Page 3, lignes 12-58 * | 1,2,5,6 ,8,10 | |
| P,A | US-A-4 742 020 (ROY) * Résumé; colonne 7, lignes 23-54; revendications * | 1,3-7 | |
| A | JOURNAL OF THE ELECTROCHEMICAL SOCIETY, vol. 131, no. 8, août 1984, pages 319c-320c, no. 511, Manchester, NH, US; J.P. ELLUL et al.: "Electrical conduction and breakdown of thin polyoxides" | | |
| A | JAPANESE JOURNAL OF APPLIED PHYSICS, vol. 25, no. 4, avril 1986, pages L291-L293, Tokyo, JP; T. OHSHIMA et al.: "A super thin film transistor in advanced poly Si films" | | DOMAINES TECHNIQUES RECHERCHES (Int. Cl.4)<br><br>H 01 L<br>C 30 B |
| D,A | THIN SOLID FILMS, vol. 124, 1985, pages 171-177, Elsevier Sequoia, Lausanne, CH; R. BISARO et al.: "Crystallization study of chemically vapour-deposited amorphous silicon films by in situ X-ray diffraction" | | |

Le présent rapport a été établi pour toutes les revendications

| Lieu de la recherche | Date d'achèvement de la recherche | Examinateur |
|---|---|---|
| LA HAYE | 18-05-1989 | GELEBART Y.C.M. |